Europäisches Patentamt

European Patent Office

Office européen des brevets

(11) Publication number: **0 368 483**
**A2**

# EUROPEAN PATENT APPLICATION

(21) Application number: **89310498.4**

(22) Date of filing: **12.10.89**

(51) Int. Cl.⁵: **C30B 19/02, C30B 29/28, G02B 6/42, G02F 1/09**

(30) Priority: **11.11.88 JP 285090/88**

(43) Date of publication of application:
**16.05.90 Bulletin 90/20**

(84) Designated Contracting States:
**DE FR GB**

(71) Applicant: **FUJI ELECTROCHEMICAL CO.LTD.**
**36-11 Shinbashi 5-chome**
**Minatoku Tokyo 105(JP)**

(72) Inventor: **Umezawa, Hiromitsu**
**389, Washizu Kosai-shi**
**Shizuoka-ken(JP)**
Inventor: **Anma, Yasuhiro**
**432, Nishinoshima Iwata-shi**
**Shizuoka-ken(JP)**

(74) Representative: **Kyle, Diana et al**
**ELKINGTON AND FIFE Beacon House 113**
**Kingsway**
**London WC2B 6PP(GB)**

(54) **Magneto-optical material.**

(57) A magneto-optical material, in which part of the iron site of a bismuth-substituted terbium-iron garnet is substituted with aluminum. The magneto-optical material of the invention has a small temperature coefficient of the Faraday rotation and a small light absorption and, at the same time, a large Faraday rotation at room temperature in spite of a single layer film structure having a magnetic garnet single crystal.

EP 0 368 483 A2

The present invention relates in general to a magnetic garnet single crystal for use in optical isolators, optical circulators, optical switches, etc. wherein Faraday effect is utilized, and more particularly, the present invention provides a magneto-optical material wherein part of the iron site of a bismuth-substituted terbium-iron garnet is substituted with aluminum.

In various instruments wherein, e.g. , a semiconductor laser is used as a light source, return of light reflected by the end face of a photoconnector or the like to the laser as the light source brings about a change in the oscillation mode, which causes occurrence of noise. An optical isolator has been used for the purpose of preventing this return light.

A bulk YIG (yttrium-iron garnet) single crystal prepared by the flux method or FZ method has been widely used for a Faraday rotator of the optical isolator.

However, in recent years, studies on an increase in the film thickness of a magnetic garnet single crystal film grown by LPE (Liquid Phase Epitaxial) have been progressed, and the magnetic garnet single crystal film has been partly put to practical use. The LPE method makes it possible to easily conduct Bi (bismuth) substitution which remarkably increases the negative Faraday rotation of the magnetic garnet and further has an advantage that the time necessary for growth is short. For this reason, the LPE method has been regarded as being advantageous in the production cost and also in production of a high-performance magneto-optical material.

Examples of the characteristics required to the magnetic garnet include:

(1) small susceptibility of Faraday rotation to temperature and

(2) small light absorption.

When the magnetic garnet single crystal film is to be produced by the LPE method, it is also necessary to meet the following requirements:

(3) large Faraday rotation per unit length and small difference in thermal expansion between the substrate and the film.

When the magnetic garnet is used for an optical isolator, a change in the Faraday rotation with temperature brings about a lowering in the high isolation attained at room temperature due to the temperature change of the external environment.

In order to express the temperature dependence, a temperature coefficient, $\beta$, of Faraday rotation at room temperature ($25\,^{\circ}$C) is defined by the following equation:

$$\beta = \frac{\theta_{F0}\,^{\circ}C - \theta_{F50}\,^{\circ}C}{50} \quad (\deg / \,^{\circ}C)$$

wherein $\theta_{F0}\,^{\circ}$C is the Faraday rotation angle at $0\,^{\circ}$C and $\theta_{F50}\,^{\circ}$C is the Faraday rotation angle at $50\,^{\circ}$C.

In this case, the temperature coefficient, $\beta$, of bulk YIG widely used at the present time is 0.035 deg/$^{\circ}$C at a wavelength, $\lambda$, of 1.3 $\mu$m.

However, the bulk single crystal has drawbacks such as an increase in the cost due to the necessity of much time for growth and necessity of a high degree of fabrication and an increase in the crystal length necessary for rotating the plane of polarization by $45\,^{\circ}$.

On the other hand, in the case of the bismuth substituted garnet thick film, the two following methods have been proposed for the purpose of reducing the temperature coefficient, $\beta$, of the Faraday rotation.

One of the proposals is a method wherein elements, such as Tb (terbium) and Dy (dysprosium), capable of exhibiting positive and large contributions to Faraday effect or elements, such as Y (yttrium), capable of increasing the Neel temperature is used as "R" (a rare earth element) in a magnetic garnet single layer film represented by the formula $R_{3-x}Bi_xFe_5O_{12}$, wherein R is a rare earth element.

Journal of Magnetic Society of Japan, Vol. 10, No. 2, p. 151 (1986) describes that in experiments wherein Gd, Yb, and Tb are used as R with variation of x, a composition of the formula $Dy_{2.5}Bi_{0.5}Fe_5O_{12}$ exhibits the minimum $\beta$ value, i.e., substantially the same $\beta$ value as that of bulk YIG and a Faraday rotation at room temperature, $\theta_F$, of -900 deg/cm at $\lambda$ = 1.3 $\mu$m and -600 deg/cm at $\lambda$ = 1.55 $\mu$m.

The Institute of Electronics, Information & Communication Engineers (IEICE) Technical Report CPM86-36 (1986) describes that in experiments wherein Er,Yb, Tm, Lu, Gd, Dy, and Y are used as R, Y(Yttrium) exhibits the highest Neel temperature and a small $\beta$ value but has the disadvantage of having large saturation magnetization and that $(YbTbBi)_3Fe_5O_{12}$, wherein Yb and Tb are used as R in a Yb to Tb ratio of 1 : 3.65, has a $\beta$ value of 0.05 deg/$^{\circ}$C and a $\theta_F$ value at room temperature of -1800 deg/cm at $\lambda$ = 1.3 $\mu$m and -1200 deg/cm at $\lambda$ = 1.55 $\mu$m.

Abstract 3aA-2 of the 12th Annual Conference on Magnetics in Japan (1988) describes that $Yb_{0.7}Tb_1$.

$_3Fe_5O_{12}$ exhibits a $\theta F$ value at room temperature of -2400 deg/cm at $\lambda$ = 1.3 $\mu$m and a $\beta$ value of 0.07 deg/°C.

In another method, a double layer structure comprising a Bi-substituted magnetic garnet having a positive temperature coefficient $\beta$ and a magnetic garnet having a large negative $\beta$ value is adopted, and each film thickness is properly selected, thereby making the overall temperature coefficient $\beta$ zero.

Abstract 29p-ZE-15 of the 34th Symposium of The Japan Society of Applied Physics (1987) describes that the overall $\beta$ value becomes zero in a combination of $(GdBi)_3(FeAlGa)_5O_{12}$ with $(YbTbBi)_3Fe_5O_{12}$. Similarly, Abstract 31a-ZF-5 of the 34th Symposium of The Japan Society of Applied Physics (1987) describes that the overall $\beta$ value becomes substantially zero in a combination of $(BiLuGd)_3Fe_5O_{12}$ with $(BiGd)_3(FeGa)_5O_{12}$.

A magneto-optical material comprising the above-described Bi-substituted magnetic garnet single crystal thick film prepared by the conventional LPE method has a drawback that, as described above, $(GdBi)_3(FeAlGa)_5O_{12}$ exhibits a very large temperature coefficient $\beta$ of the Faraday rotaion.

The single layer film represented by the formula $R_{3-x}Bi_xFe_5O_{12}$ (wherein R is a rare earth element) in which no iron site is substitued is disadvantageous in that not only the light absorption is large but also it is liable to bring about cracking during growth due to a large difference in the coefficient of thermal expansion between the substrate and the film.

Although the double layer structure can make the temperature coefficient $\beta$ a substantially zero, it has drawbacks such as high susceptibility to cracking during growth and increase in the cost due to necessity of much time for growth and complicated steps.

In $Tb_{3-x}Bi_xFe_{5-y}Ga_yO_{12}$ prepared by the flux method, the Faraday rotation is as low as -1100 deg/cm at $\lambda$ = 1.3 $\mu$m. Therefore, when this film is grown by the LPE method, it is necessary to increase the film thickness, which however unfavorably brings about cracking.

An object of the present invention is to eliminate the above-described drawbacks of the prior art.

Another object of the present invention is to provide a new magneto-optical material having a small temperature coefficient $\beta$ of the Faraday rotation and a small light absorption.

A further object of the present invention is to provide a mageto-optical material having a large Faraday rotation at room temperature.

A still further object of the present invention is to provide a magneto-optical material of a single layer film structure having a magnetic garnet single crystal.

Another object of the present invention is to provide a magneto-optical material which can be produced in a high yield because of less susceptibility to cracking during the growth by virtue of its coefficient of thermal expansion similar to that of the substrate.

The magneto-optical material according to the present invention comprises a magnetic garnet single crystal having a composition represented by the following general formula: $Tb_{3-x}Bi_xFe_{5-y}Al_yO_{12}$
wherein $0.8 \leqq x \leqq 1.3$ and
$0 < y \leqq 0.5$.

At the outset, the fundamental aspect of the present invention will be described. Substitution of Bi for part of the rare earth site is useful for increasing the Faraday rotation of a single crystal having a rare earth-iron garnet structure. In order to improve the temperature coefficient 8 of the Faraday rotation, it is effective to use, as the rare earth element, Tb having great contribution to the improvement in the temperature coefficient $\beta$ of the Faraday rotation.

Regarding light absorption, it is known that when the atomicity of part of $Fe^{3+}$ ion changes to form $Fe^{2+}$ or $Fe^{4+}$, the $Fe^{2+}$ or $Fe^{4+}$ absorb light. Substitution of a nonmagnetic ion for Fe causative of the problem is useful for solving the problem. Further, the substitution of a nonmagnetic ion for Fe can reduce the difference in the coefficient of thermal expansion between the substrate and the film, the difference bringing about cracking.

However, in general the replacement of the Fe site has been believed to bring about a lowering in the Faraday rotation and an increase in the temperature coefficient of the Faraday rotation.

In view of the above, the present inventors have grown single crystal films having various compositions and made studies thereon, and as a result have found a suitable composition, which has led to the completion of the present invention.

The aluminum has been selected in the present invention because of:

(a) small ion radius

(b) high stability in the trivalent state and

(c) no absorption in the wavelength used.

Although the substitution of a nonmagnetic ion for the Fe site reduces the Faraday rotation, the small ion radius as described in the above item (a) can make up for the reduction in the Faraday rotation through an increase in the amount of Bi substitution.

The composition represented by the formula $Tb_{3-x}Bi_xFe_{5-y}Al_yO_{12}$ (wherein: $0.8 \leq x \leq 1.3$ and $0 < y \leq 0.5$) does not bring about any deterioration of the temperature coefficient ß of the Faraday rotation, is small in the light absorption, and further capable of realizing an increase in the Faraday rotation at room temperature.

In this kind of material, a film is formed preferably on a substrate by the LPE method. The difference in the lattice constant at room temperature between the substrate and the film should be 0.01 A or less for the purpose of making internal strain in the case of use as a magneto-optical material zero. Since the coefficient of thermal expansion of the substrate is different from that of the film, the difference in lattice constant between both the materials increases at 800°C and reaches 0.1% or more. The larger the thickness of the film, the larger the internal strain at growth temperature. Specifically, when a garnet wherein no Fe site is substituted is used in combination with a substrate having a thickness of 400 μm, the film is liable to bring about cracking when the film thickness exceeds 300 μm. Further, when the film thickness exceeds 500 μm, it is very difficult to grow a crack-free film.

For this reason, with consideration of provision of an abrasion margin of 50 μm, it is necessary that the polarization face of light be rotated by 45° in a film thickness of 450 μm or less, i .e., the Faraday rotation be 1000 deg/cm or more. In order to attain a Faraday rotation of 1000 deg/cm or more at $\lambda = 1.55$ μm, it is necessary that the Faraday rotation be 3/2 times, i .e., about 1500 deg/cm or more in the case of $\lambda = 1.3$ μm.

In the present invention, substitution of a nonmagnetic Al ion for the Fe site reduces the difference in the coefficient of thermal expansion and the difference in lattice constant between the substrate and the film during growth, which renders the film less susceptible to cracking.

The invention is further illustrated by the following example, but is not limited to this embodiment.

Example:

A single cristal substrate having a composition represented by the formula $(CaMgGd)_3(ZrGa)_5O_{12}$ was used, and various magnetic garnet single crystal films represented by the general formula $Tb_{3-x}Bi_xFe_{5-y}Al_yO_{12}$ were grown on the substrate by the LPE (liquid phase epitaxial) method to prepare samples. At the same time, for comparison, a sample was prepared for a single layer film wherein y is zero, i . e. , no Fe site is substituted. Each sample was subjected to measurements of the Faraday rotation, $\theta_F$ (deg/cm), the temperature coefficient of the Faraday rotation, ß (deg/°C), the light loss (dB), and the maximum film thickness (μm) for forming the film without cracking. The sample compositions and the results of measurements are shown in Table 1.

Table 1

| | Composition | $\theta_F$ deg/cm | $\beta$ deg/°C | Light absorption dB | Max. film thickness μm |
|---|---|---|---|---|---|
| Comp. Ex. | $Tb_{2.1}Bi_{0.9}Fe_5O_{12}$ | -1450 | 0.035 | 0.5 | 400 |
| Present invention | $Tb_{1.95}Bi_{0.05}Fe_{4.85}Al_{0.15}O_{12}$ | -1480 | 0.045 | 0.4 | 450 |
| | $T_{1.85}Bi_{1.15}Fe_{4.75}Al_{0.25}O_{12}$ | -1580 | 0.052 | 0.2 | 500 |
| | $Tb_{1.70}Bi_{1.30}Fe_{4.50}Al_{0.50}O_{12}$ | -1980 | 0.060 | 0.2 | 500 |

Although the temperature coefficient ß slightly increases with an increase in the amount of substitution of Al for the Fe site, it is possible to increase the amount of substitution of Bi for the Tb site, which contributes to an increase in the Faraday rotation. Further, it is apparent that an increase in the amount of Al substitution lowers the light absorption and can increase the maximum film thickness for forming a film without cracking.

The maximum value of the amount, y, of Al substitution is about 0.5 from the viewpoint of the temperature coefficient ß of the Faraday rotation. The maximum value of the amount, x, of Bi substitution is about 1.3.

As described above, the magneto-optical material of the present invention comprises a Bi-substituted Tb-iron garnet single crystal wherein part of the Fe site is substituted with Al, which enables attainment of excellent effects including a reduction in the temperature coefficient of the Faraday rotation, a reduction in the light absorption, and an increase in the Faraday rotation at room temperature.

Therefore, e.g., in the case of the LPE method, as opposed to the double layer structure of the prior art, there is no need of forming two magnetic garnet films each having a suitable thickness, which brings about an advantage that the number of steps of growth of the crystal and fabrication can be halved.

Further, when a film having the above-described composition is grown by the LPE method through the use of $(CaMgGd)_3(ZrGa)_5O_{12}$ as a substrate, the film can be prepared in a high yield with less susceptibility to cracking.


**Claims**

1. A magneto-optical material comprising a magnetic garnet single crystal and having a composition represented by the following general formula:

$$Tb_{3-x}Bi_xFe_{5-y}Al_yO_{12}$$

wherein $0.8 \leq x \leq 1.3$ and
$0 < y \leq 0.5$.

2. A magneto-optical material according to claim 1, wherein a film of said magneto-optical material is disposed on a substrate by liquid epitaxial growth, wherein said substrate is composed of a single crystal having a composition represented by the formula $(CaMgGd)_3(ZrGa)_5O_{12}$ and a lattice constant at room temperature ranges from 12.490 to 12.498 A.

3. A magneto-optical material according to claim 2, wherein the difference in lattice constant at room temperature between said substrate and said film is 0.01 A or less.

5